# EUROPÄISCHE PATENTSCHRIFT

(11) **EP 2 288 247 B1**
(45) Veröffentlichungstag und Bekanntmachung des Hinweises auf die Patenterteilung: **01.05.2013**
(21) Anmeldenummer: 09168359.9
(22) Anmeldetag: 21.08.2009
(51) Int. Cl.: H05K 7/20, G06F 1/20, F04D 33/00

(54) **Automatisierungssystem mit Kühleinheit**
Automation system with cooling unit
Système d'automatisation doté d'une unité de refroidissement

(43) Veröffentlichungstag der Anmeldung: 23.02.2011
(73) Patentinhaber: Siemens Aktiengesellschaft, 80333 München (DE)
(72) Erfinder: Busch, Klaus, 92224 Amberg (DE)

(56) Entgegenhaltungen:
- EP-A1- 1 762 725
- EP-A2- 1 020 911
- EP-B1- 1 415 342
- US-A- 4 674 004
- US-A- 4 931 904

## Beschreibung

### Beschreibung

### Automatisierungssystem mit Kühleinheit

Die Erfindung betrifft ein Automatisierungssystem umfassend eine Baugruppe mit einem Gehäuse und einer elektronischen Komponente, wobei zur Kühlung der elektronischen Komponente an dem Gehäuse eine Kühleinheit angeordnet ist.

Automatisierungssysteme, wie beispielsweise speicherprogrammierbare Steuerungen, mit unterschiedlichen Automatisierungskomponenten, weisen im Inneren einer Baugruppe elektronische Komponenten auf, welche beim Betrieb Verlustwärme erzeugen. Da diese modular aufbaubaren Automatisierungssysteme vorzugsweise im industriellen Umfeld Anwendung finden, ist in der Regel aufgrund der rauen Umgebungsbedingungen, wie beispielsweise eine erhöhte Umgebungstemperatur, eine aktive Kühlung der Automatisierungssysteme bzw. der Baugruppen mit ihren darin enthaltenen elektronischen Komponenten notwendig.

Ein Automatisierungssystem nach dem Oberbegriff von Anspruch 1 wird in EP 1 415 342 B1 offenbart.

Nach dem Stand der Technik werden diese Baugruppen vorzugsweise mit unterhalb der Baugruppen angeordneten Axiallüftern gekühlt. Nachteilig an der Kühlung der Baugruppen mit Axiallüftern ist es, dass die Axiallüfter bauartbedingt einen erhöhten Platzbedarf unterhalb der Baugruppen aufweisen. Weiterhin ist es von Nachteil, dass Lüfter, insbesondere bei Umgebungstemperaturen von größer 55 bis 60°C, nur eine beschränkte Lebensdauer aufweisen. Somit ist ein Lüfter eine Wartungskomponente, welche am Ende ihrer Lebensdauer ausgetauscht werden muss. Ist ein solcher Austausch eines Lüfters notwendig, so kommt es zwangsläufig zu einem Anlagenstillstand, wobei die Anlage während des Austausches des beschriebenen Automatisierungssystems nicht gesteuert wird, das ist für den Betreiber der Anlage von Nachteil.

Der Erfindung liegt die Aufgabe zugrunde, ein Automatisierungssystem mit einer Kühleinheit anzugeben, welches über einen großen Zeitraum wartungsfrei betrieben werden kann bzw. eine Kühleinheit aufweist, welche verschleißfrei arbeitet.

Die Erfindung löst die eingangs genannte Aufgabe durch die Kombination der Merkmale nach Anspruch 1, wobei die Kühleinheit eine Kammer mit einem beweglichen Element und einem Medium aufweist, wobei das bewegliche Element in der Kammer derart angeordnet ist, dass ein Volumen der Kammer in einen ersten Volumenanteil und einem zweiten Volumenanteil aufgeteilt ist, wobei eine mit dem beweglichen Element in Verbindung stehende Antriebseinheit, das bewegliche Element zyklisch in eine den ersten und den zweiten Volumenanteil verändernde Hin- und Herbewegung versetzt, wobei über eine in der Kammer angeordnete erste Öffnung aufgrund der Volumenänderung das Medium zur Kühlung in die Baugruppe gelangt.

Das bewegliche Element ist vorzugsweise als eine membranartige Platte ausgestaltet, welche an den Seitenwänden verschleißfrei und elastisch befestigt ist, so dass das bewegliche Element bzw. die Membrane in der Kammer hin und her schwingen kann ohne dass ein Verschleiß an dem beweglichen Element entsteht. Dieser verschleißfreie Betrieb des beweglichen Elementes ist im Hinblick auf die Wartungsfreiheit eines zu kühlenden Automatisierungssystems von besonderem Vorteil. Ein Anlagenbetreiber muss nun nicht mehr ein notwendiges Wartungsintervall für die Kühleinheiten einhalten und kann somit seinen industriellen Prozess ohne einen Wartungsstopp durchgehend betreiben.

Weiterhin ist es von großem Vorteil, dass das bewegliche Element vorzugsweise flächig ausgeprägt ist und dadurch die Kühleinheit einen wesentlich geringeren Platzbedarf einnimmt, als es bei Kühleinheiten mit Axiallüftern der Fall ist. Denn egal ob ein Radiallüfter, Axiallüfter oder Diagonallüfter eingesetzt wird, kann bei den genannten Lüftergruppen gesagt werden, dass aufgrund ihres Funktionsprinzips von schräggestellten Luftlamellen, welche einen Volumenstrom erzeugen, die bauliche und konstruktiv bedingte Ausdehnung eines solchen Lüfters immer größer sein wird, als ein vorzugsweise flächig ausgeprägtes bewegliches Element, welches ausgestaltet ist eine Hin- und Herbewegung auszuführen. Für Automatisierungssysteme, welche bezogen auf den Platzbedarf kritisch sind, ist ein Aufbaukonzept mit einer, gegenüber Lüftern, flachen Kühleinheit mit dem beweglichen Element, beispielsweise unterhalb einer Baugruppe von Vorteil.

In einer weiterführenden Ausgestaltung der Erfindung ist die Kühleinheit zur Montage an der Baugruppe mit lösbaren Verbindungsmitteln ausgestaltet, wobei die Verbindungsmittel in das Gehäuse eingreifen. Eine Möglichkeit der Ausgestaltung ist beispielsweise, dass die Verbindungsmittel als Verrasthaken ausgestaltet sind, wobei die Verrasthaken an der Kühleinheit angebracht sind und so auf einfache Art und Weise in eine Baugruppe, entweder unterhalb der Baugruppe oder seitlich von der Baugruppe eingesteckt und eingerastet werden können.

In einer weiteren Ausgestaltung weist die Kühleinheit ein Steuermittel zur Steuerung der Antriebseinheit auf. Das Steuermittel ist vorzugsweise als eine elektronische Steuerschaltung ausgebildet, welche die Antriebseinheit ansteuert und dafür sorgt, dass das bewegliche Element zyklisch eine Hin-und Herbewegung ausführt. Die Antriebseinheit könnte beispielsweise in Form von Tauchspulen ausgestaltet sein, wobei in die Tauchspulen wiederum Eisenkerne eintauchen, welche mit dem beweglichen Element verbunden sind. Durch die Ansteuerung der Tauchspulen mit elektrischen Wechselsignalen der Steuereinheit, kann das bewegliche Element in die für die Volumenänderungen notwendige Hin- und Herbewegung versetzt werden. Weiterhin kann über die Steuereinheit eine Frequenz variabel eingestellt werden, über die einstellbare Frequenz kann die Antriebseinheit beispielsweise mit 50 Hz oder mit 100 Hz angesteuert werden und über diese unterschiedliche Ansteuerung kann ein Volumenstrom, welcher zur Kühlung in die Baugruppe gelangt, gesteuert und auf notwendige Kühlverhältnisse angepasst werden.

In einer weiter bevorzugten Ausgestaltung weist die Kühleinheit ein Kontaktmittel auf, welches ausgestaltet ist, die Kühleinheit mit der Baugruppe steckbar, elektrisch zu verbinden. Da die Antriebseinheit und das Steuermittel für ihren Betrieb mit elektrischer Spannung versorgt werden müssen ist es vorteilhaft, wenn die Kühleinheit ein passendes Kontaktmittel, wie einen Steckverbinder aufweist, welcher beim zuvor erwähnten Aufrasten der Kühleinheit auf die Baugruppe mit einem entsprechenden Gegenstück in der Baugruppe elektrisch Kontakt aufnimmt und somit die Energieversorgung der Antriebseinheit und des Steuermittels gewährleistet ist.

In einer optimierten Ausgestaltung ist die Kühleinheit derart an der Baugruppe angeordnet, dass die erste Öffnung einer im Gehäuse angeordneten Eintrittsöffnung gegenübersteht. Bei dem zuvor genannten beispielhaften Aufbau mit einer Antriebseinheit aus einem Tauchspulenmagnetsystem und einer Membran für entsprechend periodische Schwingungen wird über die Öffnung ein periodischer Luftimpuls, vorzugsweise direkt in Richtung der zu kühlenden Bauelemente innerhalb der Baugruppe, abgesetzt.

Weiterhin ist das Absetzen von periodischen Luftimpulsen verbessert, weil die Kammer erfindungsgemäß eine zweite Öffnung aufweist, wobei die erste Öffnung in einem ersten Kammerteil für den ersten Volumenanteil und die zweite Öffnung in einem zweiten Kammerteil für den zweiten Volumenanteil angeordnet ist. Demnach kann bei einer Hinbewegung des beweglichen Elementes ein Luftimpuls durch die erste Öffnung austreten und bei der darauffolgenden Rückbewegung des beweglichen Elementes kann ein Luftimpuls durch die zweite Öffnung austreten. Die beiden austretenden Luftimpulse, welche bei periodischem Betrieb zu einem kontinuierlichen Luftstrom werden, können die elektronischen Komponenten innerhalb der Baugruppe effektiv kühlen.

Dabei ist es besonders vorteilhaft, dass in der erfindungsgemäßen Ausgestaltung ein Mediumführungskanal mit der zweiten Öffnung derart in Verbindung steht, dass das aus der zweiten Öffnung austretende Medium zu einer weiteren Eintrittsöffnung umleitbar ist. Ist das vorzugsweise flächig ausgeprägte bewegliche Element im Wesentlichen parallel zu einer Seitenwand des Gehäuses der Baugruppe ausgerichtet, so bliebe ohne das Vorhandensein des Mediumführungskanals der weitere Luftimpuls bzw. ein daraus entstehender Luftstrom ungenutzt. Durch den Mediumführungskanal, welcher als eine Art Umleitung ausgestaltet ist, kann der zweite Luftimpuls bzw. der daraus entstehende zweite Luftstrom ebenfalls zur Kühlung genutzt werden. Dabei ist der Mediumführungskanal derart angeordnet, dass der zweite Luftimpuls innerhalb der Kühleinheit um 180°C zu seiner Austrittsrichtung innerhalb der Kühleinheit gedreht wird.

Weiterhin ist es von Vorteil, wenn die Kühleinheit mit der Kammer, dem Mediumführungskanal, dem Steuermittel und den Verbindungsmitteln als eine bauliche Einheit ausgestaltet ist, welche lösbar an die Baugruppe montierbar ist. Je nach Entwärmungskonzept für das Automatisierungssystem kann die Kühleinheit flexibel an die Baugruppen gesteckt oder platziert werden, je nach dem wie es die momentane Einbausituation erfordert.

Ein flexibles Aufbaukonzept eines Automatisierungssystems erreicht man dadurch, dass bei einem Automatisierungssystem aufweisend eine Mehrzahl von Baugruppen zumindest eine zuvor genannte Kühleinheit vorhanden ist, wobei die erste Öffnung der Kammer mit einem Leitmittel zum Leiten des Mediums zu den Baugruppen an einer ersten Einlassöffnung des Leitmittels in Verbindung steht und das Leitmittel eine Mehrzahl von Auslassöffnungen aufweist, wobei das Leitmittel derart angeordnet ist, dass eine erste Auslassöffnung mit einem ersten Eintrittsbereich der ersten Baugruppe und eine zweite Auslassöffnung mit einem zweiten Eintrittsbereich einer zweiten Baugruppe zur Kühlung in Verbindung steht. Bei dieser Alternative eines Aufbaukonzeptes für ein Automatisierungssystem ist es von Vorteil, dass die Kühleinheit nun nicht mehr nur für eine Baugruppe des Automatisierungssystems die Kühlfunktion übernimmt, sondern über das Leitmittel kann der Kühlmittelstrom, beispielsweise Luft, zu anderen Baugruppen geführt werden. Dabei ist es besonders vorteilhaft, dass die erste Öffnung mit dem Leitmittel verbunden ist und auch die zweite Öffnung mit dem Leitmittel verbunden ist. Durch die abwechselnde Hin- und Herbewegung des beweglichen Elementes kann zyklisch arbeitend ein Luftmimpuls über die erste Öffnung in das Leitmittel gestoßen werden und ein weiterer Luftimpuls über die zweite Öffnung ebenfalls in das Leitmittel gestoßen werden.

In einer anderen alternativen Ausgestaltung eines Automatisierungssystems mit mehreren Baugruppen weist eine erste Baugruppe und eine zweite Baugruppe je eine Kühleinheit auf, wobei die Kühleinheiten Steckverbinder zum hintereinander Schalten von einer Mehrzahl von Kühleinheiten aufweisen und eine Versorgungsspannung von einer ersten Kühleinheit zu einer zweiten Kühleinheit weiterleitbar ist. Bei diesem Kühlkonzept sind beispielsweise auf einer Hutschiene mehrere Baugruppen nebeneinander angeordnet und jede Baugruppe weist an ihrer Unterseite eine Kühleinheit auf, so ist es von Vorteil, dass nur eine erste Kühleinheit Einspeiseklemmen für die Versorgungsspannung aufweisen muss. Die in die erste Kühleinheit eingespeiste Versorgungsspannung wird über die ineinander gesteckten Steckverbinder zu jeder weiteren Kühleinheit durchgeschleift.

Anhand der Figur werden weitere Merkmale und Ausführungsbeispiele eines Automatisierungssystems mit einer Kühleinheit beschrieben. Es zeigen:
- FIG 1: ein Automatisierungssystem mit einer unterhalb einer Baugruppe angeordneten Kühleinheit (eine Seite der Membran erzeugt einen Luftstrom),
- FIG 2: ein weiteres Automatisierungssystem mit einer unterhalb einer Baugruppe angeordneten Kühleinheit (beide Seiten der Membran erzeugen einen Luftstrom zum Kühlen),
- FIG 3: ein weiteres Automatisierungssystem in einem ersten Aufbaukonzept und
- FIG 4: ein weiteres Aufbaukonzept für Kühleinheiten eines Automatisierungssystems.

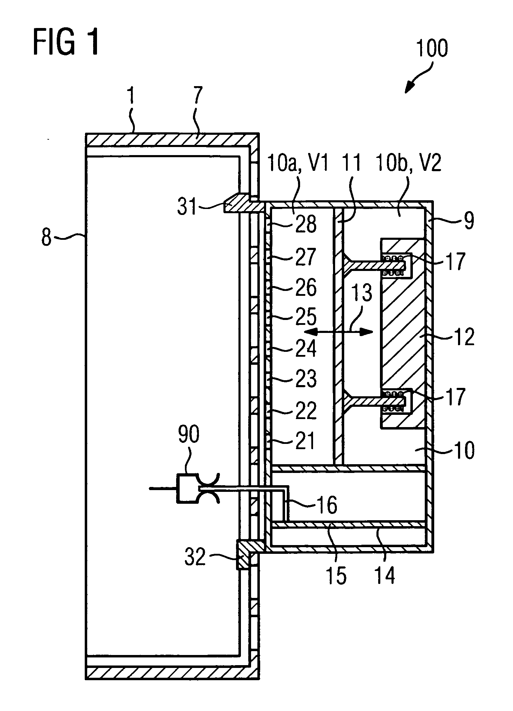

In FIG 1 ist ein Automatisierungssystem 100 umfassend eine Baugruppe 1 mit einem Gehäuse 7 und einer elektronischen Komponente 8, wobei zur Kühlung der elektronischen Komponente 8 an dem Gehäuse 7 unterhalb eine Kühleinheit 9 angeordnet ist. Die Baugruppe 1 ist als ein kastenförmiges Gehäuse 7 mit Lufteintrittsöffnungen ausgebildet. Die Kühleinheit 9, welche über ein erstes Verbindungsmittel 31 und ein zweites Verbindungsmittel 32 an der Baugruppe 1 angeordnet ist, weist innerhalb einer Kammer 10 ein bewegliches Element 11 auf. Das bewegliche Element 11 ist als eine flexible Membrane ausgestaltet und mit ihren Enden an den Seitenwänden der Kammer 10 schwingend gelagert. Eine Antriebseinheit 12 ist als eine Antriebseinheit 12 mit einer Tauchspule 17 ausgestaltet, wobei in der Tauchspule 17 ein magnetisches Verbindungselement angeordnet ist. Das magnetische Verbindungselement ist wiederum an dem beweglichen Element 11 an zwei unterschiedlichen Stellen angeordnet, so dass bei einem Stromfluss durch die Tauchspule 17 das bewegliche Element 11 in eine Hin- und Herbewegung 13 versetzt werden kann.

Das bewegliche Element 11 ist derart in der Kammer 10 angeordnet, dass ein erster Kammerteil 10a und ein zweiter Kammerteil 10b gebildet ist. In jedem dieser Kammerteile 10a,10b befindet sich ein Medium zum Kühlen der elektronischen Komponente 8. Im Folgenden wird als Kühlmedium die Umgebungsluft beschrieben, es ist aber ebenso denkbar als Kühlmedium ein beliebiges Kühlmedium in die beiden Kammerteile 10a und 10b einzubringen. Das in diesem Beispiel erwähnte Kühlmedium Luft soll für die Erfindung nicht einschränkend wirken.

In einer Außenwand des ersten Kammerteils 10a sind beispielhaft acht Auslassöffnungen für Luftimpulse angeordnet, nämlich eine erste Auslassöffnung 21 bis eine achte Auslassöffnung 28. Die erste Öffnung 21 bis zur achten Öffnung 28 sind derart am Gehäuse 7 angeordnet, dass die Öffnungen 21,...,28 Lufteintrittsöffnungen des Gehäuses gegenüberstehen. Bei einer Hin- und Herbewegung 13 des beweglichen Elementes 11 können Luftimpulse über die Öffnungen 21,...,28 austreten und zur Kühlung der elektronischen Komponente 8 in die Baugruppe 1 gelangen. Werden über ein Steuermittel 14 die Tauchspule 17 derart angeregt, dass das bewegliche Element 11 zur Baugruppe 1 ausgelenkt wird, so wird der in dem ersten Kammerteil 10a enthaltende Volumenanteil V1 komprimiert und über die Öffnungen 21,...,28 können Luftimpulse zur Kühlung der Elektronikkomponente 8 austreten. Bei einer Anregung der Tauchspule 17 derart, dass das bewegliche Element 11 sich von der Baugruppe 1 weg bewegt, wird über die Öffnungen 21,...,28 Luft wieder in den ersten Kammerteil 10a einströmen, so dass sich bei einer erneuten Bewegung des beweglichen Elementes 11 in Richtung der Baugruppe 1 neue Luftimpulse zur Kühlung der Elektronikkompenente 8 bilden können.

Das Steuermittel 14 weist eine Leiterplatte 15 mit elektronischen Bauteilen zur Steuerung der Antriebseinheit 12 auf. Auf der Leiterplatte 15 ist ein Kontaktmittel 16 angeordnet. Innerhalb der Baugruppe 1 auf der elektronischen Komponente 8 ist ein Steckverbinder 90 angeordnet, welcher auf der Elektronikkomponente 8 mit einer für das Steuermittel 14 notwendigen Versorgungsspannung verschaltet ist. Durch ein Montieren der Kühleinheit 9 an der Baugruppe 1 rastet das Kontaktmittel 16 des Steuermittels 14 in den Steckverbinder 90 der Elektronikkomponente 8 ein und somit kann das Steuermittel 14 mit Energie versorgt werden. Bei einem Anstecken der Kühleinheit 9 an die erste Baugruppe 1 ist es von Vorteil wenn die zuvor genannten Verbindungsmittel 31,32 als Verrastungselemente ausgestaltet sind, dabei ist, beispielsweise das zweite Verbindungsmittel 32, als ein rechtwinkliger Haken ausgestaltet, welcher in ein Lüftungsgitter der ersten Baugruppe 1 eingesteckt werden kann und die Kühleinheit 9 kann mit einer Schwenkbewegung in Richtung der Baugruppe 1 geführt werden kann, wobei das erste Verbindungsmittel 31 als ein Verrastungselement mit einer Gleitkuppe ausgestaltet ist und diese Gleitkuppe durch Drücken der Kühleinheit 9 gegen die für das Verbindungsmittel 31 vorbereitete Lufteintrittsöffnung in diese einschnappt und durch ein Widerlager an der Baugruppe 1 fest aber lösbar gehalten wird. Die Verbindung des ersten Verbindungsmittels 31 ließe sich beispielsweise durch einen Eingriff mit einem Schraubendreher wieder lösen, wobei der Schraubendreher das elastisch ausgeformte Verbindungsmittel 31 leicht herunterdrückt, so dass es aus der Lufteintrittsöffnung wieder herausrutschen kann.

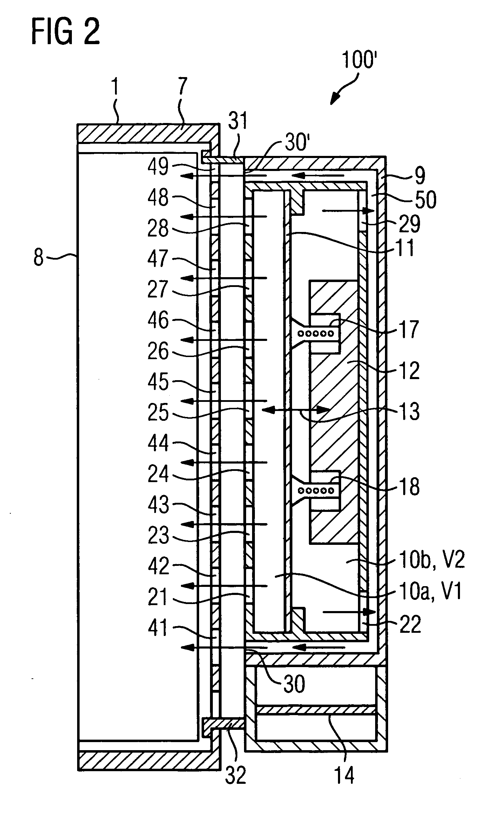

Gemäß FIG 2 ist ein weiteres Automatisierungssystem 100' in einer anderen Aufbauweise dargestellt. Die Baugruppe 1 mit ihrer Elektronikkomponente 8 weist in dieser Ausgestaltungsvariante an ihrer Unterseite eine Mehrzahl von Lufteintrittsöffnungen auf. Im Ganzen weist die Unterseite der Baugruppe 1 neun Lufteintrittsöffnungen auf. Eine erste Lufteintrittsöffnung 41 bis eine neunte Lufteintrittsöffnung 49. Ähnlich wie in der zuvor beschriebenen FIG 1 sind das erste Verbindungsmittel 31 und das zweite Verbindungsmittel 32 durch weitere Öffnungen in der Baugruppe 1 in diesen weiteren Öffnungen verrastet, so dass die Verbindungsmittel 31,32, welche mit der Kühleinheit 9 eine bauliche Einheit bilden, fest aber lösbar in der Unterseite der Baugruppe 1 angeordnet sind.

Die Kühleinheit 9 weist das aus FIG 1 bekannte bewegliche Element 11, die Antriebseinheit 12, die Tauchspule 17 und das Steuermittel 14 auf. In dieser Ausgestaltungsvariante ist die Kammer 10 ebenfalls in einen ersten Kammerteil 10a und einen zweiten Kammerteil 10b mit jeweils einem ersten Volumenanteil V1 und einem zweiten Volumenanteil V2 aufgeteilt.

Ähnlich der Anordnung nach FIG 1 sind bei diesem Ausführungsbeispiel im ersten Kammerteil 10a sieben Öffnungen zum Austritt von Luftimpulsen direkt unterhalb der Eintrittsöffnungen im Gehäuse 7 der Baugruppe 1 angeordnet. Dabei steht eine erste Öffnung 21 einer ersten Eintrittsöffnung 42 gegenüber und eine dritte Öffnung 23 steht einer zweiten Eintrittsöffnung 43 gegenüber usw. bis eine achte Öffnung 28 einer siebten Eintrittsöffnung 48 gegenübersteht.

Im Gegensatz zur Ausführung nach FIG 1 ist bei dieser Ausführungsvariante die zweite Öffnung 22 im zweiten Kammerteil 10b angeordnet. Da die Kühleinheit 9 mit dem flächig ausgeprägten beweglichen Element 11 im Wesentlichen waagerecht unterhalb der Baugruppe 1 angeordnet ist, liegt die zweite Öffnung 22 zu weit entfernt von den im Gehäuse 7 angeordneten Lufteintrittsöffnungen. Mit einem Mediumführungskanal 50, welcher den ersten Kammerteil 10a und den zweiten Kammerteil 10b umschließt ist es möglich, dass ein durch die zweite Öffnung austretender Luftimpuls (durch Pfeil angedeutet) über den Mediumführungskanal 50 zu einer zehnten Öffnung 30 geführt wird und in eine neunte Eintrittsöffnung 49 zusätzlich zu den anderen Luftimpulsen ebenfalls zur Kühlung in die Baugruppe 1 eintreten kann. Die zweite Öffnung 22 ist dabei linksseitig von der Antriebseinheit 12 angeordnet, rechtsseitig der Antriebseinheit 12 ist eine zusätzliche neunte Öffnung 29 im zweiten Kammerteil 10b angeordnet, wobei über diese neunte Öffnung 29 ebenfalls ein zusätzlicher Luftimpuls (durch Pfeil angedeutet) über den Mediumführungskanal 50 zu einer weiteren zehnten Öffnung 30' geführt wird und in eine neunte Eintrittsöffnung 49 zur zusätzlichen Kühlung der elektronischen Komponente 8 in die Baugruppe 1 eintreten kann.

Durch den Mediumführungskanal 50 erreicht man eine Luftstromführung um eine optimale Kühlleistung zu erhalten, wobei nun quasi zeitgleich der Luftstrom ober- und unterhalb des beweglichen Elementes 11 zur Kühlung der elektronischen Komponente 8 verwendet werden kann. Der Luftstrom oberhalb des beweglichen Elementes 11, wird also durch Aussparungen, bzw. den erwähnten Öffnungen in der Kühleinheit 9 direkt in die Baugruppe 1 geführt und der weitere Luftstrom unterhalb des beweglichen Elementes, wird über den Mediumführungskanal 50 um 180° innerhalb der Kühleinheit 9 umgeleitet und kann damit auch zur Kühlung der elektronischen Komponente 8 verwendet werden, welches die Kühlleistung erheblich heraufsetzt.

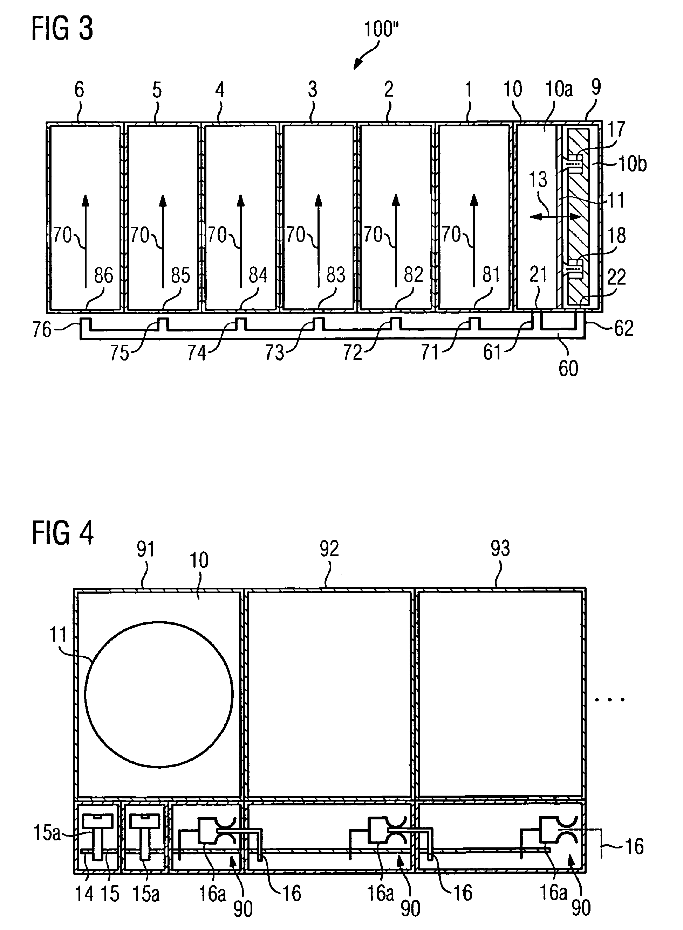

Gemäß FIG 3 ist ein weiteres Ausführungsbeispiel eines Automatisierungssystems 100" dargestellt. Das Automatisierungssystem 100" weist eine Mehrzahl von Baugruppen, nämlich von rechts nach links gesehen eine erste Baugruppe 1, eine zweite Baugruppe 2, eine dritte Baugruppe 3, eine vierte Baugruppe 4, eine fünfte Baugruppe 5 und eine sechste Baugruppe 6 auf. Rechtsseitig der ersten Baugruppe 1 ist eine Kühleinheit 9 angeordnet, wobei die erste Öffnung 21 der Kammer 10 mit einem Leitmittel 60 zum Leiten des Mediums zu den Baugruppen 1,...,6 an einer ersten Einlassöffnung 61 des Leitmittels 60 in Verbindung steht und das Leitmittel 60 eine Mehrzahl von Auslassöffnungen 71,...,76 aufweist, wobei das Leitmittel 60 derart angeordnet ist, dass eine erste Auslassöffnung 71 mit einem ersten Eintrittsbereich 81 der ersten Baugruppe 1 und eine zweite Auslassöffnung 72 mit einem zweiten Eintrittsbereich 82 der zweiten Baugruppe 2 zur Kühlung in Verbindung steht. Das Leitmittel 60 ist dabei als eine Art Kühl-Rohrleitung ausgeführt, wobei diese Kühlrohrleitung jeweils unterhalb einer Baugruppe 1,...,6 eine entsprechende Auslassöffnung zum Austritt der durch die Kühleinheit 9 erzeugten Luftimpulse aufweist. Die erzeugten Luftimpulse treten aus den Auslassöffnungen 71 bis zur Auslassöffnung 76 aus, wobei der durch die austretenden Luftimpulse erzeugte Luftstrom innerhalb der einzelnen Baugruppen 1,...,6 in der Zeichnung als ein Luftstrom 70 mit einem Pfeil angedeutet ist.

Am Beispiel der sechsten Baugruppe 6 soll stellvertretend für die übrigen Baugruppen 1,...,5 die Kühlwirkung durch den Luftstrom 70 erläutert werden. Die Kühleinheit 9 mit ihrem ersten Kammerteil 10a und ihrem zweiten Kammerteil 10b verändert durch die zyklische Hin- und Herbewegung des beweglichen Elementes 11 den in dem ersten Kammerteil 10a befindlichen Volumenanteil V1 und den in dem zweiten Kammerteil 10b befindlichen Volumenanteil V2. Diese Volumenänderung hat zur Folge, dass bei der Hin- und Herbewegung 13 über die erste Öffnung 21 ein Luftimpuls in das Leitmittel 60 gestoßen wird und bei der Rückbewegung der Hin- und Herbewegung 13 ebenfalls ein weiterer Luftimpuls über die zweite Öffnung 22 mittels der zweiten Einlassöffnung 62 des Leitmittels 60 ebenfalls in das beispielsweise als Rohrleitungssystem ausgestaltete Leitmittel 60 geführt wird. Diese eingeführten Luftimpulse breiten sich in dem Leitmittel 60 aus und gelangen ähnlich einer fortschreitenden Welle bis zu der sechsten Auslassöffnung 76, welche einem sechsten Eintrittsbereich 86 der sechsten Baugruppe 6 gegenübersteht. An dieser Stelle dringt der Luftimpuls bzw. die aus den Luftimpulsen erzeugte Luftströmung als ein Luftstrom 70 in die sechste Baugruppe 6 ein und kann, von unten nach oben gesehen, durch die sechste Baugruppe 6 strömen und eine darin befindliche elektronische Komponente kühlen.

Nach FIG 4 ist ein weiteres Ausführungsbeispiel für ein Automatisierungssystem mit einer Kühleinheit dargestellt, da hier der Fokus des Aufbaus auf der Verschaltung einer ersten Kühleinheit 91, einer zweiten Kühleinheit 92 und einer dritten Kühleinheit 93 liegt, ist das Automatisierungssystem mit seinen Baugruppen nicht mehr dargestellt. Diese Verschaltung der ersten Kühleinheit 91 bis zur dritten Kühleinheit 93 ist dabei üblicherweise unterhalb der Baugruppen angeordnet, wie sie in FIG 1 und 2 dargestellt sind.

Am rechtsseitigen Ende der dritten Kühleinheit 93 ist durch Pünktchen angedeutet, dass hier beliebig viele Kühleinheiten hintereinander gesteckt werden können und so eine Kühleinheitkaskade aufgebaut werden kann.

Ausgehend davon, dass sich die Baugruppen in der Zeichenebene befinden und somit von den Kühleinheiten verdeckt sind weist das Automatisierungssystem wiederum eine erste Baugruppe 1 und eine zweite Baugruppe 2 mit je einer Kühleinheit 91,92 auf, wobei die Kühleinheiten 91,92 Steckverbinder 90 zum Hintereinanderschalten von einer Mehrzahl von Kühleinheiten 91,92,93 aufweisen und eine Versorgungsspannung von der ersten Kühleinheit 91 zu der zweiten Kühleinheit 92 weiterleitbar ist.

Die erste Kühleinheit 91 verfügt über das zum Steuern des Antriebsmittels notwendige Steuermittel 14 und zusätzlich über Einspeiseklemmen 15a, welche auf einer Leiterplatte 15 des Steuermittels 14 angeordnet sind.

Bei einem modularen Aufbau eines Automatisierungssystems mit Kühleinheiten 91,92,93 ist es nun vorteilhaft, dass eine Versorgungsspannung für die Kühleinheiten nur an der ersten Kühleinheit 91 angeschlossen werden muss. Die Kühleinheiten weisen für ihren kaskadierbaren Aufbau jeweils ein Kontaktmittel 16 auf, welches dazu ausgestaltet ist, beim Aneinanderstecken der Kühleinheiten in ein entsprechendes Gegenkontaktmittel 16a einzurasten und somit die Weiterleitung der Versorgungsspannung zu ermöglichen.

## Patentansprüche

1. Automatisierungssystem (100) umfassend eine Baugruppe (1) mit einem Gehäuse (7) und einer elektronischen Komponente (8), wobei zur Kühlung der elektronischen Komponente (8) an dem Gehäuse (7) eine Kühleinheit (9) angeordnet ist, wobei
- die Kühleinheit (9) eine Kammer (10) mit einem beweglichen Element (11) und einem Medium zumkühlen aufweist,
- wobei das bewegliche Element (11) in der Kammer (10) derart angeordnet ist, dass ein Volumen der Kammer (10) in einen ersten Volumenanteil (V1) und einen zweiten Volumenanteil (V2) aufgeteilt ist,
- wobei eine mit dem beweglichen Element (11) in Verbindung stehende Antriebseinheit (12) das bewegliche Element (11) zyklisch in eine den ersten und den zweiten Volumenanteil (V1, V2) verändernde Hin- und Herbewegung (13) versetzt,
- wobei über eine in der Kammer (10) angeordnete erste Öffnung (21) aufgrund der Volumenänderung das Medium zur Kühlung über mindestens eine Eintrittsöffnung (42, ..., 48) des Gehäuses in die Baugruppe (1) gelangt, wobei die Kammer (10) eine zweite Öffnung (22) aufweist, wobei die erste Öffnung (21) in einem ersten Kammerteil (10a) für den ersten Volumenanteil (V1) und die zweite Öffnung (22) in einem zweiten Kammerteil (10b) für den zweiten Volumenanteil (V2) angeordnet ist,
**dadurch gekennzeichnet, dass** ein Mediumführungskanal (50) mit der zweiten Öffnung (22,29) derart in Verbindung steht, dass das aus der zweiten Öffnung (22) austretende Medium zu einer weiteren Eintrittsöffnung (41,49) des Gehäuses umleitbar ist, dabei ist der Mediumführungskanal (50) derart ausgestaltet, dass er den ersten Kammerteil (10a) und den zweiten Kammerteil (10b) umschließt.

2. Automatisierungssystem (100) nach Anspruch 1, wobei die Kühleinheit (9) zur Montage an der Baugruppe (1) mit lösbaren Verbindungsmitteln (31, 32) ausgestaltet ist, welche in das Gehäuse (7) eingreifen.

3. Automatisierungssystem (100) nach Anspruch 1 oder 2, wobei die Kühleinheit (9) ein Steuermittel (14) zur Steuerung der Antriebseinheit (12) aufweist.

4. Automatisierungssystem (100) nach einem der Ansprüche 1 bis 3, wobei die Kühleinheit (9) ein Kontaktmittel (16) aufweist, welches ausgestaltet ist die Kühleinheit (9) mit der Baugruppe (1) steckbar elektrisch zu verbinden.

5. Automatisierungssystem (100) nach einem der Ansprüche 1 bis 4, wobei die Kühleinheit (9) derart an der Baugruppe (1) angeordnet ist, dass die erste Öffnung (21) einer im Gehäuse (7) angeordneten Eintrittsöffnung (42) gegenübersteht.

6. Automatisierungssystem (100) nach einem der Ansprüche 3 bis 5, wobei die Kühleinheit (9) mit
- der Kammer (10),
- dem Mediumführungskanal (50),
- dem Steuermittel (14) und
- den Verbindungsmitteln (31, 32)
als eine bauliche Einheit ausgestaltet ist, welche lösbar an die Baugruppe (1) montierbar ist.

7. Automatisierungssystem (100) nach Anspruch 6, aufweisend eine Mehrzahl von Baugruppen (1,...,6) und zumindest eine Kühleinheit (9), wobei die erste Öffnung (21) der Kammer (10) mit einem Leitmittel (60) zum Leiten des Medium zu den Baugruppen (1,...,6)) an einer ersten Einlassöffnung (61) des Leitmittels (60) in Verbindung steht und das Leitmittel (60) eine Mehrzahl von Auslassöffnungen (71,...,76) aufweist, wobei das Leitmittel (60) derart angeordnet ist, dass eine erste Auslassöffnung (71) mit einem ersten Eintrittsbereich (81) der ersten Baugruppe (1) und eine zweite Auslassöffnung (72) mit einem zweiten Eintrittsbereich (82) einer zweiten Baugruppe (2) zur Kühlung in Verbindung steht.

8. Automatisierungssystem (100) nach Anspruch 7, aufweisend eine erste Baugruppe (1) und eine zweite Baugruppe (2) mit je einer Kühleinheit (9), wobei die Kühleinheiten (9) Steckverbinder (90) zum Hintereinanderschalten von einer Mehrzahl von Kühleinheiten (91, 92, 93) aufweisen und eine Versorgungsspannung von einer ersten Kühleinheit (91) zu einer zweiten Kühleinheit (92) weiter leitbar ist.

## Claims

1. Automation system (100) comprising an assembly (1) with a housing (7) and an electronic component (8), wherein a cooling unit (9) is arranged on the housing (7) to cool the electronic component (8), wherein
- the cooling unit (9) has a chamber (10) with a mobile element (11) and a medium for cooling,
- wherein the mobile element (11) is arranged in the chamber (10) such that a volume of the chamber (10) is divided into a first volume fraction (V1) and a second volume fraction (V2),
- wherein a drive unit (12) which is connected to the mobile element (11) cyclically displaces the mobile element (11) in a back and forth movement (13) which changes the first and the second volume fraction (V1, V2),
- wherein because of the volume change the medium for cooling enters the assembly (1) via at least one inlet opening (42, ..., 48) of the housing via a first opening (21) arranged in the chamber, wherein the chamber (10) has a second opening (21), wherein the first opening (21) is arranged in a first chamber section (10a) for the first volume fraction (V1) and the second opening (22) is arranged in a second chamber section (10b) for the second volume fraction (V2), **characterised in that**
a medium guidance channel (50) is connected to the second opening (22, 29) such that the medium exiting from the second opening (22) can be diverted to a further inlet opening (41, 49) of the housing, and the medium guidance channel (50) is configured such that it surrounds the first chamber section (10a) and the second chamber section (10b).

2. Automation system (100) according to claim 1, wherein the cooling unit (9) is configured to be mounted on the assembly (1) with detachable connection means (31, 32) which engage in the housing (7).

3. Automation system (100) according to claim 1 or 2, wherein the cooling unit (9) has a control means (14) for controlling the drive unit (12).

4. Automation system (100) according to one of claims 1 to 3, wherein the cooling unit (9) has a contact means (16) which is configured to electrically connect the cooling unit (9) to the assembly (1) in plug-in fashion.

5. Automation system (100) according to one of claims 1 to 4, wherein the cooling unit (9) is arranged on the assembly (1) such that the first opening (21) faces an inlet opening (42) arranged in the housing (7).

6. Automation system (100) according to one of claims 3 to 5, wherein the cooling unit (9) is configured as one structural unit (which can be detachably mounted on the assembly (1)) with
- the chamber (10),
- the medium guidance channel (50),
- the control means (14) and
- the connection means (31, 32).

7. Automation system (100) according to claim 6, having a plurality of assemblies (1,...,6) and at least one cooling unit (9), wherein the first opening (21) of the chamber (10) is connected to a conduction means (60) for conducting the medium to the assemblies (1,...,6) at a first inlet opening (61) of the conduction means (60) and the conduction means (60) has a plurality of outlet openings (71, ..., 76), wherein the conduction means (60) is arranged such that a first outlet opening (71) is connected to a first inlet region (81) of the first assembly (1) and a second outlet opening (72) is connected to a second inlet region (82) of a second assembly (2) for cooling.

8. Automation system (100) according to claim 7, having a first assembly (1) and a second assembly (2), each with a cooling unit (9), wherein the cooling units (9) have plug-in connectors (0) for serial connection of a plurality of cooling units (91, 92, 93) and a supply voltage can be further conducted from a first cooling unit (91) to a second cooling unit (92).

## Revendications

1. Système ( 100 ) d'automatisation comprenant un module ( 1 ) ayant un boîtier ( 7 ) et un composant ( 8 ) électronique, dans lequel une unité ( 9 ) de refroidissement est, pour le refroidissement du composant ( 8 ) électronique, montée sur le boîtier ( 7 ), dans lequel
- l'unité ( 9 ) de refroidissement a une chambre ( 10 ) ayant un élément ( 11 ) mobile et un fluide pour le refroidissement,
- dans lequel l'élément ( 11 ) mobile est disposé dans la chambre ( 10 ) de manière à ce qu'un volume de la chambre ( 10 ) soit subdivisé en une première partie ( V1 ) de volume et en une deuxième partie ( V2 ) de volume,
- dans lequel une unité ( 12 ) d'entraînement en liaison avec l'élément ( 11 ) mobile met l'élément ( 11 ) mobile cycliquement en un mouvement ( 13 ) de va et vient modifiant la première et la deuxième parties ( V1, V2 ) de volume,
- dans lequel par une première ouverture ( 21 ) pratiquée dans la chambre ( 10 ), en raison de la variation de volume, le fluide de refroidissement parvient par au moins une ouverture ( 42, ..., 48 ) d'entrée du boîtier dans le module ( 1 ), la chambre ( 10 ) ayant une deuxième ouverture ( 22 ), la première ouverture ( 21 ) étant pratiquée dans une première partie ( 10a ) de la chambre pour la première partie ( V1 ) du volume et la deuxième ouverture ( 22 ) dans une deuxième partie ( 10b ) de la chambre pour la deuxième partie ( V2 ) du volume,
**caractérisé en ce qu'**un canal ( 50 ) de conduite du fluide est en communication avec la deuxième ouverture ( 22, 29 ) de manière à ce que le fluide sortant de la deuxième ouverture ( 22 ) puisse être dévié vers une autre ouverture ( 41, 49 ) d'entrée du boîtier, le canal ( 50 ) de conduite du fluide étant tel qu'il entoure la première partie ( 10a ) de la chambre et la deuxième partie ( 10b ) de la chambre.

2. Système ( 100 ) d'automatisation suivant la revendication 1, dans lequel l'unité ( 9 ) de refroidissement est conformée pour le montage sur le module ( 1 ) par des moyens ( 31, 32 ) de liaison amovibles qui pénètrent dans le boîtier ( 7 ).

3. Système ( 100 ) d'automatisation suivant la revendication 1 ou 2, dans lequel l'unité ( 9 ) de refroidissement a un moyen ( 14 ) de commande pour la commande de l'unité ( 12 ) d'entraînement.

4. Système ( 100 ) d'automatisation suivant l'une des revendications 1 à 3, dans lequel l'unité ( 9 ) de refroidissement a un moyen ( 16 ) de contact, qui est conformé pour relier électriquement par enfichage l'unité ( 9 ) de refroidissement au module ( 1 ).

5. Système ( 100 ) d'automatisation suivant l'une des revendications 1 à 4, dans lequel l'unité ( 9 ) de refroidissement est montée sur le module ( 1 ) de manière à ce que la première ouverture ( 21 ) soit en face d'une ouverture ( 42 ) d'entrée pratiquée dans le boîtier ( 7 ).

6. Système ( 100 ) d'automatisation suivant l'une des revendications 3 à 5, dans lequel l'unité ( 9 ) de refroidissement est avec
- la chambre ( 10 ),
- le canal ( 50 ) de conduite du fluide,
- le moyen ( 14 ) de commande et
- les moyens ( 31, 32 ) de liaison constituées sous la forme d'une unité de construction, qui peut être montée de manière amovible sur le module ( 1 ).

7. Système ( 100 ) d'automatisation suivant la revendication 6, ayant une pluralité de modules ( 1, ..., 6 ) et au moins une unité ( 9 ) de refroidissement, la première ouverture ( 21 ) de la chambre ( 10 ) étant en liaison avec un moyen ( 60 ) de conduite pour la conduite du fluide au module ( 1, ..., 6 ) en une première ouverture ( 61 ) d'entrée du moyen ( 60 ) de conduite et le moyen ( 60 ) de conduite ayant une pluralité d'ouvertures ( 71, ..., 76 ) de sortie, le moyen ( 60 ) de conduite étant disposé de manière à ce qu'une première ouverture ( 71 ) de sortie soit en liaison pour le refroidissement avec une première zone ( 81 ) d'entrée du premier module ( 1 ) et de manière à ce qu'une deuxième ouverture ( 72 ) de sortie soit en liaison pour le refroidissement avec une deuxième zone ( 82 ) d'entrée d'un deuxième module ( 2 ).

8. Système ( 100 ) d'automatisation suivant la revendication 7, ayant un premier module ( 1 ) et un deuxième module ( 2 ) ayant respectivement une unité ( 9 ) de refroidissement, les unités ( 9 ) de refroidissement ayant des liaisons ( 90 ) à enfichage pour le branchement successif d'une pluralité d'unités ( 91, 92, 93 ) de refroidissement et une tension d'alimentation pouvant continuer à être appliquée d'une première unité ( 91 ) de refroidissement et une deuxième unité ( 92 ) de refroidissement.
